# EUROPEAN PATENT APPLICATION

(11) **EP 4 572 543 A1**
(43) Date of publication of application: **18.06.2025**
(21) Application number: 23851316.2
(22) Date of filing: 25.05.2023
(51) Int. Cl.: H05K 5/02, H04M 1/02

(54) **DECORATIVE PLATE AND PREPARATION METHOD THEREFOR, AND ELECTRONIC DEVICE**

(30) Priority: 10.08.2022 CN 202210959229
(71) Applicant: BYD Company Limited, Shenzhen, Guangdong 518118 (CN)
(72) Inventor: ZHU, Qiyu, Shenzhen, Guangdong 518118 (CN); ZHAO, Lihong, Shenzhen, Guangdong 518118 (CN); LUO, Wenhai, Shenzhen, Guangdong 518118 (CN); DUAN, Feifei, Shenzhen, Guangdong 518118 (CN); ZHANG, Aodong, Shenzhen, Guangdong 518118 (CN)
(74) Representative: Mathys & Squire
(86) International application number: PCT/CN2023/096235
(87) International publication number: WO 2024/032086

(57) **Abstract**

Provided in the present application are a decorative plate and a preparation method therefor, and an electronic device. The decorative plate comprises a substrate, on the surface of one side of which a texture layer is arranged, the texture layer comprising a plurality of areas, wherein at least a plurality of areas present a change in brightness, and at least some areas comprise a plurality of texture units; and each texture unit comprises a plurality of protrusions, which are arranged in an array, each protrusion comprising a pyramid or a truncated pyramid.

## Description

### CROSS-REFERENCE TO RELATED APPLICATIONS

The present disclosure claims priority to Chinese Patent Application No. 202210959229.2 filed on August 10, 2022 and entitled "DECORATIVE PLATE, PREPARATION METHOD THEREFOR AND APPLICATION THEREOF", which is incorporated herein by reference in its entirety.

### FIELD

The present disclosure relates to the field of decorative technology, in particular to a decorative plate, a preparation method therefor, and an electronic device.

### BACKGROUND

With the rapid development of electronic devices, people have increasingly high requirements for visual effects on appearances of electronic devices, but the existing electronic devices have a relatively simple decorative appearance, monotonous textures, and insufficient appearance expressiveness, especially the monotonous changes in light and shadow effects, and cannot meet the needs of consumers.

### SUMMARY

In view of this, the present disclosure provides a decorative plate. The array arrangement of protrusion structures in the texture layer of the decorative plate can cooperate with each other to refract and reflect light at varying angles and intensities, and therefore, multiple light and shadow reflecting effects can be applied to the light source so that the decorative plate can present a light and shadow effect with gradual depth of field. In addition, the texture layer has a plurality of regions with different brightness, which ultimately enables the decorative plate to present the gradual depth of field with alternating light and dark, and have rich visual effects and a higher level of aesthetic appearance.

A first aspect of the present disclosure provides a decorative plate, the decorative plate comprising a substrate, a texture layer arranged on one side surface of the substrate, the texture layer comprising a plurality of regions, wherein at least some of the plurality of regions present a change in brightness and at least some of the regions include a plurality of texture units; each of the texture units comprising a plurality of protrusions arranged in an array, and the protrusion include a pyramid or a frustum.

In one of the texture units, each of the protrusions arranged along a first direction has a first side surface and a second side surface arranged opposite and parallel to the first direction, a plurality of the first side surfaces arranged adjacent to each other form a first reflective surface of a first blazed grating subunit and a plurality of the second side surfaces arranged adjacent to each other form a second reflective surface of the first blazed grating subunit; a plurality of the first blazed grating subunits form a first blazed grating.

In one of the texture units, each of the protrusions arranged along a second direction has a third side surface and a fourth side surface arranged opposite and parallel to the second direction, a plurality of the third side surfaces arranged adjacent to each other form a first reflective surface of a second blazed grating subunit and a plurality of the fourth side surface arranged adjacent to each other form a second reflective surface of the second blazed grating subunit; a plurality of the second blazed grating subunits form a second blazed grating; the first direction and the second direction are different.

For each texture unit, the protrusions can cooperate with each other, when the light source illuminates the decorative plate from a certain angle, the two sets of blazed gratings formed by the protrusions refract and reflect the light at different angles and intensities, and therefore, multiple light and shadow reflecting effects can be applied to the light source. Each texture unit not only presents a gradient depth of field effect like a kaleidoscope, but also presents a visual effect of "light" or "dark". In addition, by changing the extension direction of the blazed grating in the texture unit, or changing the shape of the protrusion, the light and dark effects presented by the texture unit can be changed. The texture units with different light and dark effects can be arranged at different positions on the substrate to form the regions with different brightness on the decorative plate. These regions can also form specific patterns, which can further enrich the appearance of the decorative plate and improve its market competitiveness.

A second aspect of the present disclosure provides a preparation method for a decorative plate, comprising the following steps:
(1) a pattern corresponding to a first blazed grating and a second blazed grating with different extension directions is designed, the first blazed grating includes a plurality of first blazed grating subunits arranged in parallel along the first direction, the second blazed grating includes a plurality of second blazed grating subunits arranged in parallel along the second direction, the first blazed grating and the second blazed grating are superimposed to form an intersection between any of the first blazed grating subunits and any of the second blazed grating subunits, the intersections are deformed to ensure that any one of the intersections independently is a protrusion, the protrusion includes a pyramid or a frustum, and a unit pattern is obtained;
(2) a texture pattern of the decorative plate is designed, the texture pattern is divided into a plurality of regions, at least some of the regions are divided into a plurality of pattem units, each of the pattern units is filled with a unit pattem to ensure that at least some of the plurality of regions in the texture pattern are different in brightness and the pattem units in the single region are similar in brightness, and a pattern file is obtained;
(3) a texture layer corresponding to the filled texture pattern is formed on the surface of the substrate according to the pattem file to obtain the decorative plate according to the first aspect of the present disclosure.

The preparation method described above is highly controllable, can obtain decorative plates with different visual effects through flexible variation of parameters, is simple to process, and is suitable for large scale industrial production.

According to a third aspect of the present disclosure, an electronic device comprising the decorative plate according to the first aspect of the present disclosure is provided. The electronic device has a dazzling appearance effect, which can improve appearance expressiveness and product competitiveness of the electronic device.

### BRIEF DESCRIPTION OF THE DRAWINGS

FIG. 1 is a grayscale view of a decorative plate according to an example of the present disclosure;
FIG. 2A is a grayscale view from a first viewing angle of a decorative plate according to another example of the present disclosure;
FIG. 2B is a grayscale view from a second viewing angle of a decorative plate according to another example of the present disclosure;
FIG. 2C is a grayscale view from a third viewing angle of a decorative plate according to another example of the present disclosure;
FIG. 3 is a schematic diagram of the structure of a common blazed grating;
FIG. 4 is a schematic diagram of a cross-sectional structure of a decorative plate according to an example of the present disclosure;
FIG. 5 is a schematic diagram of a cross-sectional structure along a first direction of a texture unit of a decorative plate according to an example of the present disclosure;
FIG. 6 is a top view of the partial structure of a texture unit of a decorative plate according to an example of the present disclosure;
FIG. 7 is a schematic diagram of the partially enlarged structure of FIG. 6;
FIG. 8 is a top view of a first blazed grating in a texture unit of a decorative plate according to an example of the present disclosure;
FIG. 9 is a top view of a second blazed grating in a texture unit of a decorative plate according to an example of the present disclosure;
FIG. 10 is a schematic diagram of a first blazed grating subunit and a second blazed grating subunit in a texture unit of a decorative plate according to an example of the present disclosure;
FIG. 11 shows the relationship between the extension direction of a single blazed grating and the corresponding brightness;
FIG. 12 is a schematic diagram of the relative position relationship between a single blazed grating, the unit pattern obtained by superimposing two blazed gratings and the light source;
FIG. 13 shows the relationship between the cross-sectional shape of a single grating subunit of a single blazed grating and the corresponding brightness;
FIG. 14A is a schematic diagram of the principle of light reflection by a single grating subunit of a single blazed grating;
FIG. 14B is a cross-sectional view of grating subunits of two different blazed gratings;
FIG. 14C is a front view of a protrusion in a texture unit of a decorative plate viewed from a first direction according to an example of the present disclosure;
FIG. 15 is a schematic diagram of the cross-sectional structure along the first direction of a texture unit of a decorative plate according to example 4 of the present disclosure;
FIG. 16 is a grayscale view of a decorative plate according to example 5 of the present disclosure.
reference signs: 100-decorative plate; 10-substrate; 20-texture layer; 30-region; 40-texture unit; 50-protrusion; 60-first blazed grating; 61-first blazed grating subunit; 611-first reflective surface; 612-second reflective surface; 70-second blazed grating; 71-second blazed grating subunit; 711-third reflective surface; 712-fourth reflective surface.

### DETAILED DESCRIPTION

With the rapid development of electronic devices, consumers may tend to choose products with a dazzling appearance when selecting products, and products with a light and shadow variation appearance are particularly favored by the majority of consumers. But now the industry relies on changing the arrangement direction of the same blazed grating at different positions on the shell to achieve the overall light and shadow variation of the shell. The pattern of the shell is often too simple and lacks texture.

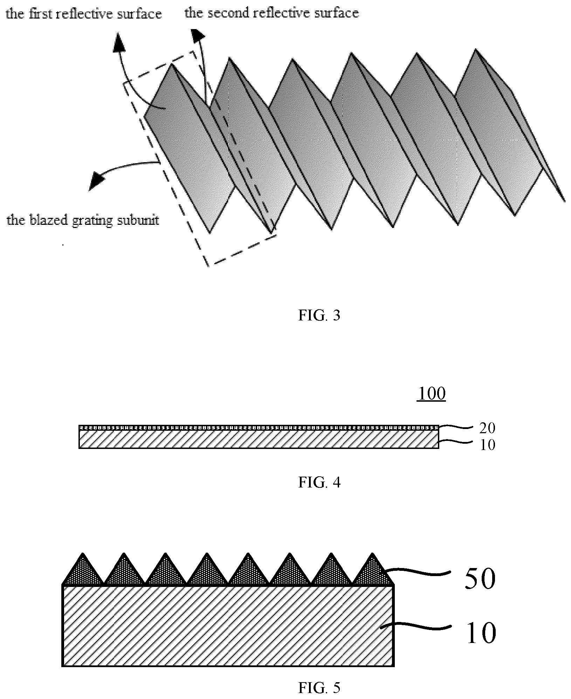

With reference to FIG. 3 below, the structure of a common blazed grating is introduced briefly. A blazed grating has a plurality of grating subunits arranged in parallel, and each grating subunit has two intersecting reflective surfaces. It can be understood that when the angle between the reflective surface and the bottom surface of the blazed grating is changed, the reflective surfaces at different angles present different refractive and reflective effects on the light. When a light source illuminates on the surface of the blazed grating, the more light reflected by the reflective surface to the human eye, the brighter the reflective surface is visually, and vice versa, the dimmer it becomes.

Under the same incident light angle, the angle α between the reflective surface and the incident light determines how much reflected light the human eye can receive. The greater the value of α (α greater than or equal to 90°), the less light is reflected to the human eye, and the darker the reflective surface is visually; the smaller the value of α, the brighter the reflective surface is visually.

Based on the above principle, in order to solve the problem of relatively single light and shadow effects on the appearance of electronic devices on the current market, an example of the present disclosure provides a decorative plate.

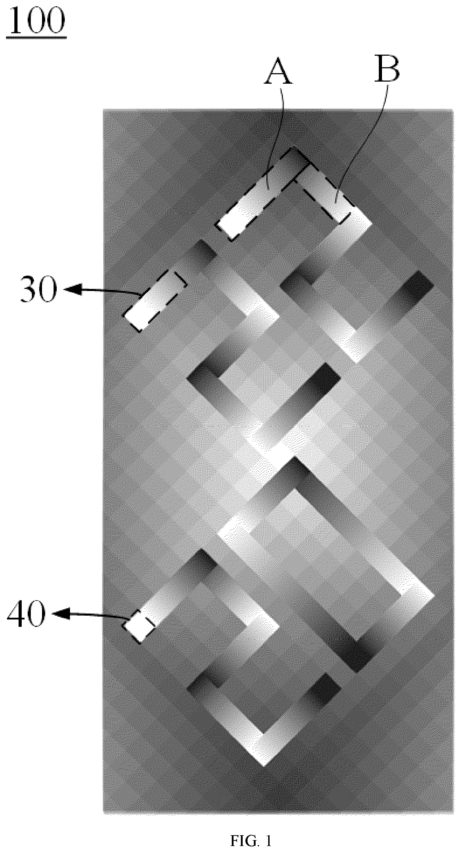

Specifically, with reference to FIGS. 1 to 2C and 4 to 10, an example of the present disclosure provides a decorative plate 100 comprising a substrate 10, a texture layer is arranged on one side surface of the substrate (see FIG. 4), the texture layer 20 comprising a plurality of regions 30, at least some of the plurality of regions 30 present a change in brightness and at least some of the regions 30 comprise a plurality of texture units 40 (see FIG. 1); each of the texture unit 40 comprises a plurality of protrusions 50 arranged in an array (see FIG. 5), and the protrusion 50 include a pyramid or a frustum; it can be understood that some regions only include one texture unit 40.

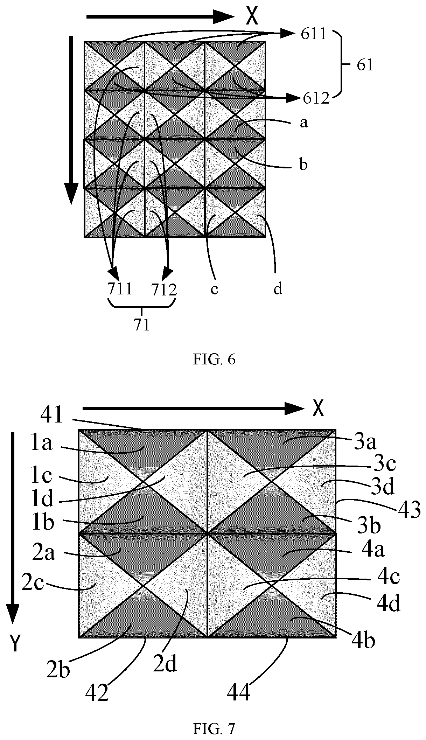

With reference to FIGS. 6 to 10, in one texture unit 40, each of the protrusions 50 arranged along the first direction X has a first side surface a and a second side surface b arranged opposite and parallel to the first direction X, a plurality of the first side surfaces a arranged adjacent to each other form a first reflective surface 611 of a first blazed grating subunit 61 and a plurality of the second side surfaces b arranged adjacent to each other form a second reflective surface 612 of the first blazed grating subunit 61; a plurality of the first blazed grating subunits 61 form a first blazed grating 60.

In one texture unit 40, each of the protrusions 50 arranged along the second direction Y has a third side surface c and a fourth side surface d arranged opposite and parallel to the second direction Y, a plurality of the third side surfaces c arranged adjacent to each other form a third reflective surface 711 of a second blazed grating subunit 71 and a plurality of the fourth side surface d arranged adjacent to each other form a fourth reflective surface 712 of the second blazed grating subunit 71; a plurality of the second blazed grating subunits 71 form a second blazed grating 70; and the first direction X and the second direction Y are different.

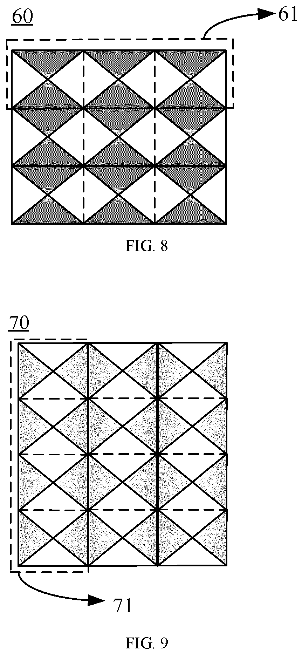

The relative position of each protrusion 50 and each blazed grating is explained in more detail below. Each texture unit 40 includes the first blazed grating 60 and the second blazed grating 70 arranged non-parallel, wherein each blazed grating has a plurality of grating subunits, each grating subunit has two reflective surfaces, and the two reflective surfaces have a certain angle. With reference to FIG. 7, exemplarily, in this example, the texture unit 40 includes the first protrusion 41 and the third protrusion 43 arranged in sequence along the first direction X. The first protrusion 41 has the first side surface 1a and the second side surface 1b arranged opposite and parallel to the first direction X, and the third protrusion 43 has the first side surface 3a and the second side surface 3b arranged opposite and parallel to the first direction X. The first reflective surface of the first blazed grating subunit is formed by arranging the adjacent first side surfaces 1a and 3a, and the second reflective surface is formed by arranging the adjacent second side surfaces 1b and 3b. Similarly, the texture unit 40 includes the first protrusion 41 and the second protrusion 42 arranged in sequence along the second direction Y, the first protrusion 41 has the third side surface 1c and the fourth side surface 1d arranged opposite and parallel to the second direction Y, and the second protrusion 42 has the third side surface 2c and the fourth side surface 2d arranged opposite and parallel to the second direction Y. The first reflective surface of the second blazed grating subunit is formed by arranging the adjacent third side surfaces 1c and 2c, and the second reflective surface is formed by arranging the adjacent fourth side surfaces 1d and 2d. The texture unit 40 further includes a fourth protrusion 44. The second protrusion 42 and the fourth protrusion 44 are arranged in sequence along the first direction X, and the third protrusion 43 and fourth protrusion 44 are arranged in sequence along the second direction Y. The fourth protrusion 44 has the first side surface 4a and the second side surface 4b arranged opposite and parallel to the first direction X and has the third side surface 4c and the fourth side surface 4d arranged opposite and parallel to the second direction Y. The first reflective surface of the first blazed grating subunit is formed by arranging the adjacent first side surfaces 2a and 4a, and the second reflective surface is formed by arranging the adjacent second side surfaces 2b and 4b. The first reflective surface of the second blazed grating subunit is formed by arranging the adjacent third side surfaces 3c and 4c, and the second reflective surface is formed by arranging the adjacent fourth side surfaces 3d and 4d. In other words, the reflective surface of each blazed grating is a serrated plane consisting of a plurality of pyramids or frustums (see FIGS. 8 and 9).

In the present disclosure, the side surface of the protrusion 50 parallel to the first direction X or the second direction Y means in particular that the bottom edge of the side surface is parallel to the first direction X or the second direction Y.

The protrusions 50 arranged in an array is arranged in each texture unit 40, the side surfaces of the adjacent projections 50 may be enclosed as an inverted pyramid, thus each texture unit 40 may form a gradual depth of field effect like a kaleidoscope. Again because the mutual cooperation between the protrusions 50 may form two sets of crossed blazed gratings, and the two sets of blazed gratings have four sets of reflective surfaces with different angles, when the light source illuminates the surface of the decorative plate 100, the four sets of staggered reflective surfaces refract and reflect the light at different angles and intensities, such that the texture unit 40 presents a visual effect of "light" or "dark", and the aforementioned gradual depth of field effect may be further enhanced. Based on this, by changing the extension direction of the blazed grating in the texture unit 40 (i.e. changing the first direction X and/or the second direction Y) or changing the angle between each reflective surface and the substrate 10 (i.e. the angle between the side surface of the protrusion 50 and the substrate 10) , the texture unit 40 can present different light and dark effects, and thus, by arranging texture units 40 with different brightness in the preset regions on the decorative plate 100, and controlling the light and dark effects of all texture units 40 in a certain region to be similar, the regions 30 with different brightness can be obtained, and the plurality of regions 30 can form a specific pattern on the decorative plate 100 to further enrich the visual effect of the decorative plate 100.

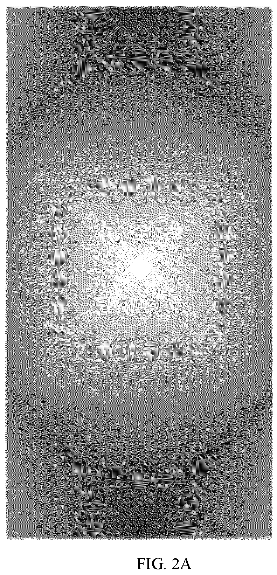

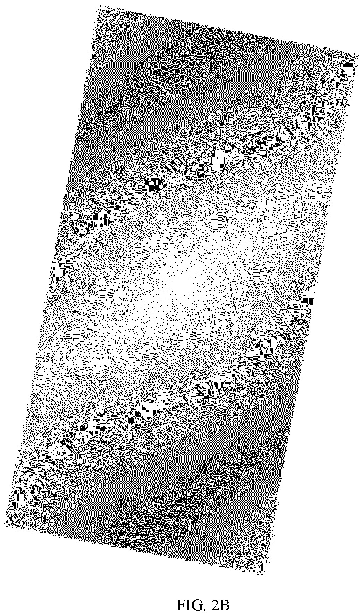

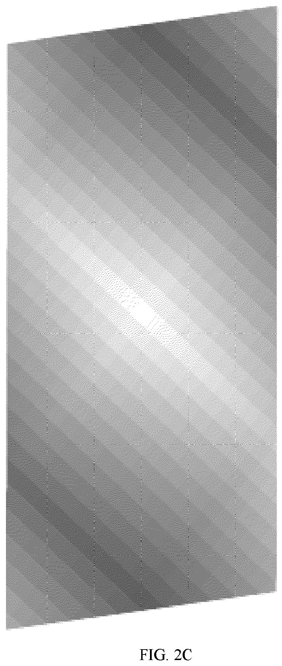

Furthermore, when the user changes the viewing angle (i.e. changes the light source direction), the angle between each reflective surface in the texture unit 40 and the incident direction of the light is also changed, and the light and dark effect presented by each texture unit 40 also changes, and accordingly, the light and dark of each region 30 may change, and further, when the user rapidly changes the viewing angle, the decorative plate 100 can present an effect of alternating flow of light and dark (see FIGS. 2A to 2C), with extremely rich visual effects. Because each texture unit has two sets of blazed gratings at the same time, it can be understood that for each texture unit, at least over two viewing angles, the texture unit 40 presents relatively high brightness and relatively dark darkness. Accordingly, this change is reflected in the light and dark variation of the region 30, which also greatly enriches the user's experience.

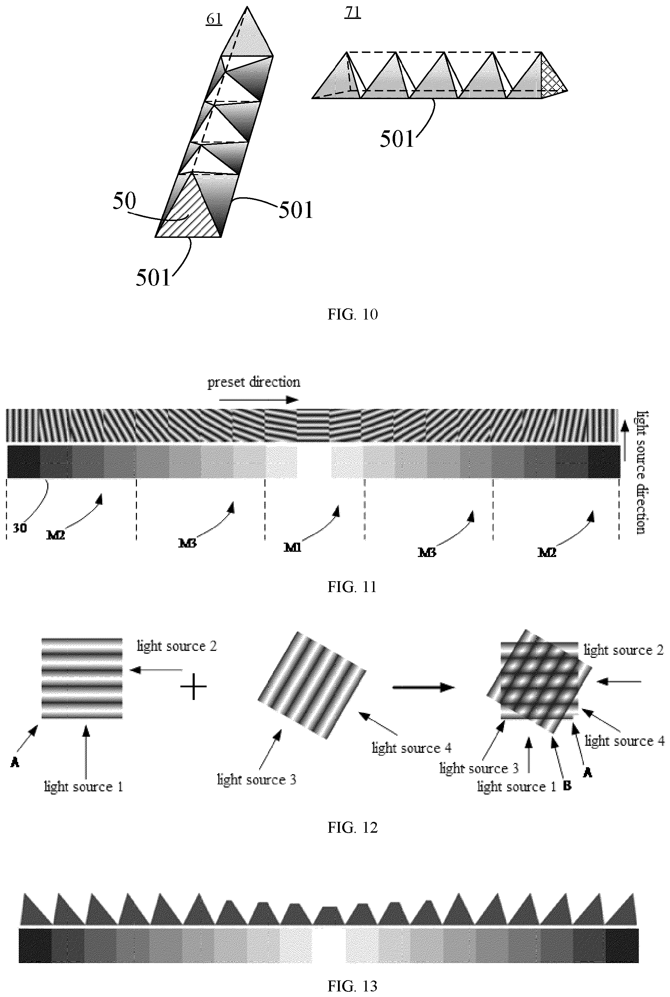

FIG. 11 shows the light and dark effects corresponding to the different extension directions of a single blazed grating. When the extension direction of the single blazed grating is perpendicular to the illumination direction of the light source, the blazed grating presents a high brightness state under the light source; when the extension direction of a single blazed grating is parallel to the illumination direction of the light source, the blazed grating presents in a darkest state under the light source. Below, with reference to FIG. 12, a detailed principle explanation will be provided on the correspondence between the direction of the light source (i.e., the user's viewing direction) and the extension direction of the blazed grating. The blazed grating A and the second blazed grating are common structures shown in FIG. 3. The first blazed grating presents the brightest visual effect under the light source 1 and the darkest visual effect under the light source 2, and the second blazed grating presents the brightest visual effect under the light source 3 and the darkest visual effect under the light source 4. The unit pattern is obtained by superimposing and fusing the first blazed grating and the second blazed grating; when the light source is moved between the light source 1 and the light source 3 (turning clockwise from the light source 1 to the light source 3, or turning counterclockwise from the light source 3 to the light source 1), the unit pattern presents a brighter visual effect. Similarly, when the light source is moved between the light source 2 and the light source 4, the unit pattern presents a brighter visual effect. When the light source changes in other angle ranges, the unit pattern presents a relatively dark visual brightness. So, it can be understood that with reference to FIGS. 8, 9 and 12, the above principle corresponds to the first blazed grating 60 and the second blazed grating 70, the first blazed grating 60 presents the high brightness under the light source 1 and the darkest under the light source 2, and the second blazed grating 70 presents the high brightness under the light source 3 and the darkest under the light source 4. Thus, by fusing the first blazed grating 60 with the second blazed grating 70, the texture unit 40 can present the high brightness state at two light source angles and the darkest state at two light source angles. As it changes between the above directions, the brightness state gradually changes between the high brightness state and the darkest state. Moreover, when the angles between the reflective surfaces of the first blazed gratings 60 and the second blazed grating 70 and the substrate 10 change, it directly causes the angle between the reflective surfaces and the incident light source to be different, and affects the light and dark state.

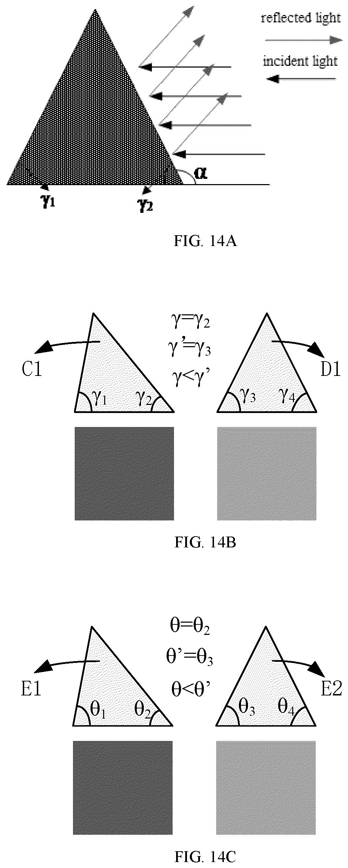

Even under the same light source (i.e. under the same viewing angle), the angle between the reflective surface of the single blazed grating and the substrate (i.e., the cross-sectional shape of the blazed grating) also significantly affects the visual brightness of the blazed grating. The principles are explained below by combining a common blazed grating. With reference to FIGS. 3, 5, and 13 to 14B, FIG. 3 shows a common blazed grating structure, FIG. 13 shows the relationship between the cross-sectional shapes of the grating subunits of the blazed gratings with different extension directions and different cross-sectional shapes under the same light source and the corresponding light and dark visual effects. FIG. 14A shows the relationship between the reflective surface of the grating subunit and the incident light source. The blazed gratings C and D are also common blazed grating structures as shown in FIG. 3, the cross-section of one grating subunit of the blazed grating C is denoted as C1, and the angles between the two reflective surfaces corresponding to the two side edges of C1 and the substrate 10 are γ₁ and γ₂, respectively. The cross-section of one grating subunit of the blazed grating D is denoted as D1, and the angles between the two reflective surfaces corresponding to the two side edges of D1 and the substrate 10 are γ₃ and γ₄, respectively. It is defined that γ is the minimum value of γ₁ and γ₂, γ' is the minimum value of γ₃ and γ₄, γ*<*γ*',* and then the brightness of the blazed grating C is lower than the brightness of the blazed grating D.

Understandably, with reference to FIGS. 1, 8, 9 and 14C, the first blazed grating 60 and the second blazed grating 70 in the present disclosure differ from a common blazed grating only in that "the reflective surfaces of both are serrated planes", and the both are formed by the the protrusions 50 arranged in array, and the cross-sectional shape of the grating subunit described above corresponds to the front view shape of the protrusion 50 as viewed from the first direction X or the second direction Y in this disclosure, and it can be seen that the brightness change of the texture unit 40 is also affected by the shapes of the protrusions 50. With reference to FIG. 14C, the two protrusions are viewed from the first direction X, and the front view shapes of the protrusions are E1 and E2, respectively. The angles between the two side surfaces of the protrusions corresponding to the side edges of E1 and the substrate 10 are θ₁ and θ₂, respectively. The angles between the two side surfaces of the protrusions corresponding to the side edges of E2 and the substrate 10 are θ₃ and θ₄, respectively. It is defined that θ is the minimum value of θ₁ and θ₂, θ' is the minimum value of θ₃ and θ₄, and if θ<θ', from certain angles, the brightness of the protrusion corresponding to E1 is lower than the brightness of the protrusion corresponding to E2. Similarly, when the protrusions E1 and E2 are viewing from the second direction Y, the front view shape in the second direction Y also affects the brightness of the protrusions at other angles, and thus, the overall light and dark effect of the protrusion 50 will be significantly affected by the shape of protrusion 50. In general, the front view shape of each protrusion 50 viewed from the first direction X or the second direction Y is a triangle or trapezoid, or a deformed triangle or trapezoid. Taking a triangle as an example, when the bottom edge of each triangle is the same width, the greater the height of the triangle, the darker the visual effect is; when the triangles are of equal height, the wider the bottom edge of the triangle, the darker the visual effect is.

In some examples of the present disclosure, a plurality of protrusions 50 in the single texture unit 40 are uniform in shape.

It can be seen that the shapes of the protrusions 50 in each texture unit 40 can be kept uniform, and by controlling the extension direction of each blazed grating, the texture layer 20 may be divided into a plurality of regions 30 with different brightness. Alternatively, the extension directions of the blazed gratings in each texture unit 40 may be kept uniform, and by controlling the shapes of the protrusions 50 to be different, the texture layer 20 may be divided into a plurality of regions 30 with different brightness. Of course, by simultaneously controlling the extension directions of the blazed gratings and the shapes of the protrusions 50, it is possible to further enrich the light and shadow effect of the surface of the decorative plate 100, and greatly enhance the aesthetics of the decorative plate 100.

With reference to FIGS. 1 and 8 to 10, in some examples of the present disclosure, the first region A and the second region B are defined as any two adjacent regions 30, wherein at least the first reflective surfaces 611 and the second reflective surfaces 612 of some of the first blazed gratings 60 and/or the third reflective surfaces 711 and the fourth reflective surfaces 712 of some of the second blazed gratings 70 in the first region A have an extension direction different from the extension direction of the second region B; and/or the shape of the orthogonal projection of at least one of the first reflective surface 611, the second reflective surface 612, the third reflective surface 711, and the fourth reflective surface 712 on the substrate 10 is different from the shape of the second region B. When the user views the decorative plate 100 from a certain angle (i.e., the light source illuminates the decorative plate 100 from a certain direction), the extension direction of each reflective surface and the shape of the orthogonal projection of the reflective surface on the substrate 10 may significantly affect the brightness of the region. The different arrangement directions of the protrusions 50 arranged in different preset regions (i.e., the extension directions of the first blazed gratings 60 and/or the second blazed gratings 70 are different) or the different shapes of the protrusions 50 (the orthographic projection shape of the reflective surface on the substrate 10) can result in different brightness in different preset regions, and finally, regions with different brightness may be divided.

In the present disclosure, the shape of the region 30 may be regular or irregular. For example, it may be a circle, a ring, a rectangle, an irregular shape, etc.

In this disclosure, for convenience, the length direction of the decorative plate 100 is defined as a preset direction. In the same texture unit 40, the angles between the first blazed grating 60 and the second blazed grating 70 and the preset direction are not the same.

In some examples of the present disclosure, at least some regions 30 are present, the extension direction of the first blazed grating or the second blazed grating in the single region 30 (i.e. the first direction X or the second direction Y of the texture unit 40) is parallel to the preset direction, and at least some regions 30 are also present, the extension direction of the first blazed grating or the second blazed grating in a single region 30 is perpendicular to the preset direction. At this time, when the user observes the work piece, the surface of the decorative plate 100 has the highest brightness region 30 and the lowest brightness region 30, so that the light and dark alternating effect of the decorative plate 100 is most obvious.

With reference to FIG. 11, the region 30 includes a first portion M1, a second portion M2 and a third portion M3. In some examples of the present disclosure, at least some regions 30 are present, the angle between the extension direction of the first blazed grating and/or the second blazed grating in the single region 30 and the preset direction is in the range of -30° to 30° (denoted as the first portion M1), at least some regions 30 are also present, the angle between the extension direction of the first blazed grating and/or the second blazed grating in the single region 30 and the preset direction is in the range of 60° to 90° and/or -90° to -60° (denoted as the second portion M2), and yet at least some regions 30 are present, the angle between the extension direction of the first blazed grating and/or the second blazed grating in the single region 30 and the preset direction is in the range of -60° to -30° and/or 30° to 60° (denoted as the third portion M3). With reference to FIG. 11, when the angle between the blazed grating and the preset direction is in the range of -30° to 30°, the region 30 is a distinctly high brightness region when the decorative plate 100 is viewed from a direction perpendicular to the preset direction (the light source direction is perpendicular to the preset direction); the region 30 is a distinctly dark region when the angle between the extension direction of the blazed grating and the preset direction is in the range of 60° to 90° and/or -90° to -60°; when the angle between the extension direction of the blazed grating and the preset direction is in the range of -60° to -30° and/or 30° to 60° , the region 30 is a transition region with the brightness is between the above two. The texture layer 20 having the regions with the above three brightness expressions simultaneously may make a richer light and dark effect of the surface of the decorative plate 100.

In some examples of the present disclosure, the third portion M3 is located between the first portion M1 and the second portion M2. At this time, the surface of the decorative plate 100 simultaneously has high brightness regions, dark regions, and transition regions therebetween, which can make the transition between light and dark on the surface of the decorative plate 100 more natural and beautiful.

In some examples of the present disclosure, in at least some of texture unit, the extension direction of the first blazed grating forms an angle β with the extension direction of the second blazed grating in a single texture unit (i.e. the angle between the first direction X and the second direction Y), the angle β is in the range of 30° to 120°. Controlling the angle β in this range may significantly reduce the risk of moiré patterns in the texture layer 20, and the effect presented by the texture layer 20 is more able to present the fusing effect of the first blazed grating 60 and the second blazed grating 70.

In some examples of the present disclosure, at least some regions 30 are present, the γ and/or θ of each protrusion 50 in the single region 30 are in the range of greater than 0° to less than or equal to 30°, at least some regions 30 are present, the γ and/or θ of each protrusion 50 in the single region 30 are in the range of 30° to 60°, and yet at least some regions 30 are present, the γ and/or θ of each protrusion 50 in the single region 30 are in the range of 60° to 80°. At this point, the light and dark effect on the surface of decorative plate 100 is relatively rich.

In some examples of the present disclosure, the protrusions in at least some of the texture units 40 are arranged without gaps.

In other examples of the present disclosure, the protrusions in at least some of the texture units 40 are arranged apart. The spacing distance between adjacent protrusions 50 is much smaller than the minimum lateral size of the bottom surface of the protrusions 50, as a result, poor continuity between the grating subunits of the blazed grating can be avoided, and poor continuity of the reflective surfaces can be avoided, so that the light and shadow variation effect of each texture unit 40 can be effectively secured, and thus the light and shadow variation effect of the decorative plate 100 can be sufficiently secured.

In some examples of the present disclosure, the height of the protrusion 50 is in the range of 0.1 µm to 20 µm. For example, the height of protrusion 50 can be 0.1 µm, 0.5 µm, 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc. The light and shadow effect of the gradual depth of field of the decorative plate 100 can be better realized, the decorative plate 100 can also be provided with a more comfortable feel, and the contact area of a human hand with the surface of the work piece can be reduced, thereby preventing hand sweat and fingerprint residue and maintaining its gorgeous appearance over a long period of use. Note that in the present disclosure, the height of the projection 50 refers to the height difference between the highest point of protrusion 50 relative to the plane of substrate 10 and the plane of substrate 10, that is, the size of protrusion 50 in the direction perpendicular to the plane of substrate 10. Specifically, with reference to FIG. 5, the distance from the highest point of the cross-section of the projection 50 in the direction perpendicular to the plane of the substrate 10 to the plane of the substrate 10 is the height h of the projection 50, and the height h can also be calculated by the height difference between the highest and lowest points of the cross-section.

With reference to FIG. 10, in some examples of the present disclosure, each of the protrusions 50 includes a bottom surface in contact with the substrate 10, and the bottom surface is polygonal and includes a plurality of bottom edges 501. The length of the bottom edge 501 of the protrusion 50 is in the range of 1 µm to 3000 µm. In some examples, the length of the bottom edge 501 of the protrusion 50 is in the range of 30 µm to 120 µm. For example, the length of the bottom edge 501 of the protrusion 50 may be 1 µm, 5 µm, 10 µm, 30 µm, 40 µm, 50 µm, 60 µm, 70 µm, 80 µm, 90 µm, 100 µm, 110 µm, 120 µm, 150 µm, 200 µm, 500 µm, 1000 µm, 2000 µm, 3000 µm, etc. In this disclosure, when the bottom edge 501 of the protrusion 50 is a curved line or a polyline, the length of the bottom edge 501 refers to the vertical distance between two bottom edges 501. Controlling the length of the bottom edge 501 of each protrusion 50 in the above range can make the light and shadow effect of the gradual depth of field and the alternating light and dark effect of the decorative plate 100 more dazzling.

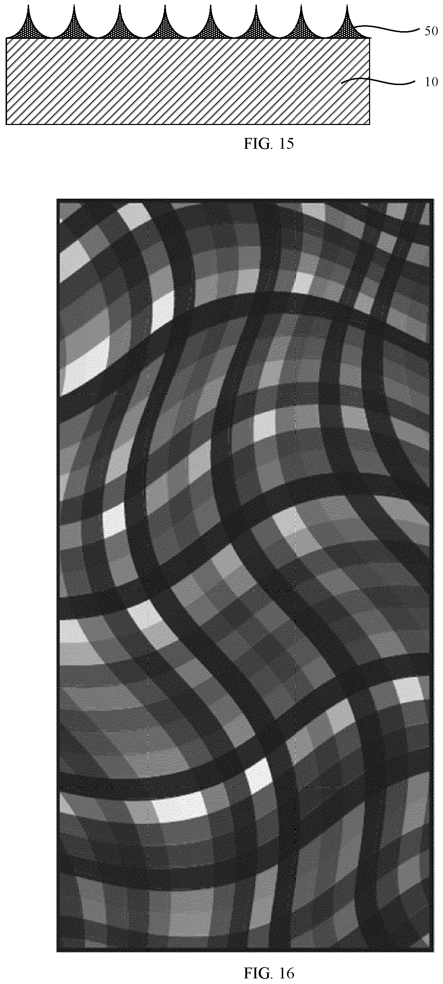

With reference to FIG. 15, in the present disclosure, the pyramids and frustums are not limited to pyramids and frustums in the strict sense, but also include variations of pyramids and frustums. In some examples of the present disclosure, a plurality of protrusions 50 are arranged on the substrate 10. Each side surface of the protrusion 50 is independently planar or curved. When the side surface of the protrusion 50 is curved (the curved surface may be convex upwards or concave downwards, see FIG. 15), the inverted pyramid formed by the cooperation between the adjacent protrusions 50 can also present a mini "distorting mirror" effect. In some examples of the present disclosure, each bottom edge of the pyramid or frustum is independently a straight line, a curved line, or a polyline.

In some examples of the present disclosure, the pyramid includes a quadrangular pyramid and the frustum includes a quadrangular frustum.

In this disclosure, the specific shape of the texture unit 40 is not limited. It may be a polygon, a circle, or an irregular shape, as long as multiple texture units 40 can merge into a continuous texture layer 20.

In some examples of the present disclosure, the outer contour line of each texture unit 40 independently includes at least one of a curved line (see FIG. 16), a straight line, and a polyline. Understandably, the outer contour line of each region 30 independently is also a curved line, a straight line, a polyline, or a combination thereof. In this case, the pattern on the surface of the decorative plate 100 is richer, variable, and highly recognizable.

In some examples of the present disclosure, at least some texture units 40 have a size greater than or equal to 150 µm. At this point, the decorative panel 100 can clearly present the outer contour line of the texture unit 40, that is, the surface of the decorative plate 100 also has a grid effect.

In some examples of the present disclosure, at least some texture units 40 have a size less than or equal to 100 µm. At this point, users cannot observe the outer contour line of texture unit 40 with the naked eye, that is, the surface of the decorative plate 100 only presents a gradual depth of field and a light and shadow variation effect, does not have the aforementioned grid effect, and is aesthetic.

In some examples of the present disclosure, at least some texture units 40 have a size greater than 100 µm and less than 150 µm. At this point, the grid effect on the surface of the decorative plate 100 is faintly visible, which can further enrich consumers' choices.

It is noted that texture unit 40 is polygonal. When the outer contour line of texture unit 40 is a straight line, the size of texture unit 40 refers to the maximum edge length of the texture unit 40; when the outer contour line of the texture unit 40 is a curve line or a polyline, the size of the texture unit 40 refers to the maximum vertical distance between the two opposite edges of the texture unit 40.

In some examples of the present disclosure, the decorative plate 100 further includes a finishing layer including one or more of a chromogenic layer, a frosting layer, and a glitter layer, and the finishing layer is arranged on the surface of the texture layer 20 and/or the substrate 10.

When decorative plate 100 is decorated with a chromogenic layer, the color change presented in each region 30 is different, and the color also changes with user's viewing angle, which is extremely ornamental.

In the present disclosure, the material and the thickness of the substrate 10 are not particularly limited, and may be selected according to user needs. Specifically, the material of the substrate includes, but is not limited to, metal, glass, ceramic, polymer composite materials, etc.

Accordingly, the present example also provides a method for preparing a decorative plate provided by the examples of the present disclosure, including the following steps:
(1) a pattern corresponding to the first blazed grating and the second blazed grating with different extension directions is designed, the first blazed grating includes a plurality of the first blazed grating subunits arranged in parallel along the first direction, the second blazed grating includes a plurality of the second blazed grating subunits arranged in parallel along the second direction, the first blazed grating and the second blazed grating are superimposed to form an intersection between any of the first blazed grating subunits and any of the second blazed grating subunits, the intersections are deformed to ensure that any one of the intersections independently is a protrusion, the protrusion includes a pyramid or a frustum, and a unit pattern is obtained;
(2) a texture pattern of the decorative plate is designed, the texture pattern is divided into a plurality of regions, at least some of the regions are divided into a plurality of pattern units. In this disclosure, some regions only include one pattern unit; each of the pattern units is filled with a unit pattern to ensure that at least some of the plurality of regions in the texture pattern are different in brightness and pattern units in the single region are similar in brightness, and a pattern file is obtained;
(3) a texture layer corresponding to the filled texture pattern is formed on the surface of the substrate according to the pattern file to obtain the decorative plate according to the examples of the present disclosure.

In the present disclosure, the deformation processing of the intersection can specifically includes: the grayscale patterns (with height parameters) of the first blazed grating and the second blazed grating are designed, the grayscale patterns of the two are superimposed and the data processing is performed: for any position, the height of the position is an average of the heights h₁, h₂ of the first blazed grating and the second blazed grating or (h₁ + h₂)/n (n is greater than 1), such that each intersection of the subunits of the first blazed grating and the second blazed grating is a pyramid or a frustum. In this disclosure, the pyramids and frustums are not limited to pyramids and frustums in the strict sense, but also include variations of pyramids and frustums.

In some examples of the present disclosure, the groove widths of the first blazed grating subunit and the second blazed grating subunit are in the range of 1 µm to 3000 µm. The groove width is the width of the bottom edge of the blazed grating subunit perpendicular to its extension direction.

In some examples of the present disclosure, methods of forming the texture layer on the surface of the substrate include laser direct writing and photolithography.

In some examples of the present disclosure, the texture layer is formed on a glass surface by photolithography, the glass with the texture layer is then UV transferred, the pattern of the texture layer is transferred on a sheet of polymeric material, and then the sheet is coated, printed and cut to obtain a texture film sheet, and finally the texture film sheet is attached to a substrate to obtain the decorative plate. The polymeric material includes, but is not limited to, one or more of polycarbonate, polyethylene terephthalate, and polymethyl methacrylate.

The examples of the present disclosure also provide an electronic device with the decorative plate provided in the examples of the present disclosure. The electronic device includes, but is not limited to, mobile phones, tablets, laptops, smartwatches, electronic cigarettes, etc. For example, the decorative plate can be processed as a case for mobile phones, tablets, laptops, smartwatches, and also in the relevant parts of electronic cigarettes, which can provide a dazzling appearance to the electronic device, and can improve appearance expressiveness and product competitiveness of the electronic device.

Furthermore, the decorative plate can also be processed as luxury name plate, which can further improve artistic properties of product.

The technical solution of the present disclosure will now be described in detail through a number of examples.

### Example 1

**In** example 1, the decorative plate is mobile phone back cover and the substrate is made of glass, wherein the protrusions in the texture unit are arranged without gaps, each protrusion is a regular quadrangular pyramid with a bottom edge length of 2 µm and a height of 6 µm, the outer contour of each texture unit is square, and the size of each texture unit is 95 µm.

### Example 2

Example 2 differs from example 1 only in that the size of the texture unit is 200 µm.

### Example 3

Example 3 differs from example 1 only in that the projection is the regular quadrangular frustum.

### Example 4

Example 4 differs from example 1 only in that the projection is the quadrangular pyramid having curved side surfaces.

### Example 5

Example 5 differs from example 1 only in that the contour lines of the texture unit are curved lines.

### Example 6

Example 6 differs from example 1 only in that the surface of decorative plate further has the chromogenic layer.

The above is an exemplary example of the present disclosure, and it should be noted that for a person skilled in the art, without departing from the principles of the present disclosure, several improvements and modifications can be made, which are also considered in the scope of protection of the present disclosure.

## Claims

1. A decorative plate (100), the decorative plate (100) comprising a substrate (10), a texture layer (20) being arranged on one side surface of the substrate (10), the texture layer (20) comprising a plurality of regions (30), at least some of the plurality of regions (30) present a change in brightness, and at least some of the regions (30) comprising a plurality of texture units (40); each of the texture units (40) comprising a plurality of protrusions (50) arranged in an array, and the protrusion (50) comprising a pyramid or a frustum;
in one of the texture units (40), each of the protrusions (50) arranged along a first direction (X) having a first side surface (a) and a second side surface (b) which are arranged opposite and parallel to the first direction (X), a plurality of the first side surfaces (a) arranged adjacent to each other forming a first reflective surface (611) of a first blazed grating subunit (61) and a plurality of the second side surfaces (b) arranged adjacent to each other forming a second reflective surface (612) of the first blazed grating subunit (61); a plurality of the first blazed grating subunits (61) forming a first blazed grating (60);
in one of the texture units (40), each of the protrusions (50) arranged along a second direction (Y) having a third side surface (c) and a fourth side surface (d) which are arranged opposite and parallel to the second direction (Y), a plurality of the third side surfaces (c) arranged adjacent to each other forming a third reflective surface (711) of a second blazed grating subunit (71) and a plurality of the fourth side surface (d) arranged adjacent to each other forming a fourth reflective surface (712) of the second blazed grating subunit (71); a plurality of the second blazed grating subunits (71) forming a second blazed grating (70);
the first direction (X) and the second direction (Y) are different.

2. The decorative plate (100) according to claim 1, wherein a first region (A) and a second region (B) are defined as any two adjacent regions (30), at least the first reflective surfaces (611) and the second reflective surfaces (612) of some of the first blazed gratings (60) and/or the third reflective surfaces (711) and the fourth reflective surfaces (712) of some of the second blazed gratings 70 in the first region (A) have an extension direction different from the extension direction of the second region (B); and/or the shape of the orthogonal projection of at least one of the first reflective surface (611), the second reflective surface (612), the third reflective surface (711), and the fourth reflective surface (712) on the substrate (10) is different from the shape of the second region (B).

3. The decorative plate (100) according to claim 1, wherein the first side surface (a), the second side surface (b), the third side surface (c) and the fourth side surface (d) independently comprise a plane and/or a curved surface.

4. The decorative plate (100) of claim 1, wherein each of the protrusions (50) comprises a bottom surface in contact with the substrate (10), the bottom surface is polygonal and comprises a plurality of bottom edges, and the plurality of bottom edges independently comprise at least one of a straight line, a curved line and a polyline.

5. The decorative plate (100) according to claim 1, wherein each of the protrusions (50) comprises a plurality of bottom edges (501) in contact with the substrate (10), the height of the protrusion (50) in a direction perpendicular to the plane of the substrate (10) is in the range of 0.1µm to 20µm, and the length of the bottom edge (501) is in the range of 1 µm to 3000 µm.

6. The decorative plate (100) according to claim 1, wherein the pyramid comprises a quadrangular pyramid and the frustum comprises a quadrangular frustum.

7. The decorative plate (100) of claim 1, wherein the outer contour line of each of the texture unit (40) independently comprises at least one of a straight line, a curved line and a polyline.

8. The decorative plate (100) of claim 1, wherein at least some of the texture units (40) have a size less than or equal to 100 µm.

9. The decorative plate (100) of claim 1, wherein at least some of the texture units (40) have a size greater than or equal to 150 µm.

10. The decorative plate (100) according to claim 1, wherein in the same texture unit (40), the first blazed grating (60) and the second blazed grating (70) are angled differently from a preset direction, and the preset direction is the length direction of the decorative plate (100).

11. The decorative plate (100) according to claim 10, wherein the extension direction of the first blazed grating (60) or the second blazed grating (70) in the single region (30) is parallel to the preset direction in some of the regions (30), and the extension direction of the first blazed grating (60) or the second blazed grating (70) in the single region (30) is perpendicular to the preset direction in the remaining regions (30).

12. The decorative plate (100) according to claim 10, wherein some of the plurality of regions (30) comprises a first portion (M1), a second portion (M2) and a third portion (M3), in the first portion (M1) the angle between the extension direction of the first blazed grating (60) and/or the second blazed grating (70) in the single region (30) and the preset direction is in the range of -30° to 30°; in the second portion (M2) the angle between the extension direction of the first blazed grating (60) and/or the second blazed grating (70) in the single region (30) and the preset direction is in the range of 60° to 90° and/or -90° to -60°; in the third portion (M3) the angle between the extension direction of the first blazed grating (60) and/or the second blazed grating (70) in the single region (30) and the preset direction is in the range of -60° to -30° and/or 30° to 60°.

13. The decorative plate (100) according to claim 12, wherein the third portion (M3) is located between the first portion (M1) and the second portion (M2).

14. The decorative plate (100) according to claim 1, wherein in at least some of the texture units (40), the extension direction of the first blazed grating (60) forms an angle (β) with the extension direction of the second blazed grating (70) in the single texture unit (40), and the angle (β) is in the range of 30° to 120 °.

15. The decorative plate (100) of claim 1, wherein the shapes of the plurality of protrusions (50) in the single texture unit (40) are uniform.

16. The decorative plate (100) of claim 1, wherein the decorative plate (100) further comprises a finishing layer comprising one or more of a chromogenic layer, a frosting layer, and a glitter layer, and the finishing layer is arranged on the surface of the texture layer (20) and/or the substrate (10).

17. A preparation method for a decorative plate (100), comprising the following steps:
(1) designing a first blazed grating and a second blazed grating with different extension directions, the first blazed grating comprising a plurality of first blazed grating subunits arranged in parallel along a first direction (X), the second blazed grating comprising a plurality of second blazed grating subunits arranged in parallel along a second direction (Y), superimposing the first blazed grating and the second blazed grating to form an intersection between any of the first blazed grating subunits and any of the second blazed grating subunits, deforming the intersections to ensure that any one of the intersections independently is a protrusion, the protrusion comprising a pyramid or a frustum, and obtaining a unit pattern;
(2) designing a texture pattern of the decorative plate, the texture pattern being divided into a plurality of regions, at least some of the regions being divided into a plurality of pattern units, each of the pattern units being filled with a unit pattern to ensure that at least some of the plurality of regions in the texture pattern are different in brightness and the pattern units in the single region are similar in brightness, and obtaining a pattern file;
(3) forming a texture layer corresponding to the filled texture pattern on a surface of a substrate according to the pattem file to obtain the decorative plate according to any one of claims 1 to 15.

18. The preparation method according to claim 17, wherein the methods for forming the texture layer on the surface of the substrate comprises laser direct writing and photolithography.

19. The preparation method according to claim 17, wherein the groove widths of the first blazed grating subunit and the second blazed grating subunit are in the range of 1 µm to 3000 µm.

20. An electronic device, the electronic device comprising the decorative plate (100) according to any one of claims 1 to 16.
